**Europäisches Patentamt**

**European Patent Office**

**Office européen des brevets**

(11) Numéro de publication : **0 562 916 B1**

## (12) FASCICULE DE BREVET EUROPEEN

(45) Date de publication du fascicule du brevet :
**09.11.94 Bulletin 94/45**

(51) Int. Cl.⁵ : **G05F 1/648,** G05F 3/24, G11C 16/06

(21) Numéro de dépôt : **93400689.1**

(22) Date de dépôt : **17.03.93**

(54) **Dispositif de génération de tensions de référence.**

(30) Priorité : **18.03.92 FR 9203213**

(43) Date de publication de la demande :
**29.09.93 Bulletin 93/39**

(45) Mention de la délivrance du brevet :
**09.11.94 Bulletin 94/45**

(84) Etats contractants désignés :
**DE FR GB IT**

(56) Documents cités :
**EP-A- 0 271 686**
**WO-A-89/06068**

(73) Titulaire : **SGS-THOMSON MICROELECTRONICS S.A.**
**7, Avenue Galliéni**
**F-94250 Gentilly (FR)**

(72) Inventeur : **Yero, Emilio, Cabinet BALLOT-SCHMIT**
**7, rue Le Sueur**
**F-75116 Paris (FR)**

(74) Mandataire : **Schmit, Christian Norbert Marie et al**
**Cabinet Ballot-Schmit**
**7, rue Le Sueur**
**F-75116 Paris (FR)**

## Description

L'invention concerne la génération de plusieurs tensions de référence dans un circuit intégré, à partir d'une source de tension externe et d'un dispositif de génération. Elle s'applique en particulier aux mémoires non-volatiles.

De nombreux circuits intégrés nécessitent en interne plusieurs tensions de référence pour des applications à faible ou à fort courant de charge. En particulier, les mémoires non-volatiles nécessitent de nombreuses tensions de référence pour des opérations de lecture, de test, de programmation ou d'effacement. Par exemple, pour programmer une cellule mémoire flash EPROM, il faut disposer d'une tension dite de programmation Vpp de douze volts sur la grille de contrôle de la cellule, d'une tension de ligne de bit appliquée au drain de la cellule de six volts et d'une tension de source de zéro volts. Mais dans un mode de test, la tension appliquée au drain de la cellule ne sera plus de 6 mais de 7 volts. Il faut donc pouvoir disposer de ces deux tensions de référence. Ces exigences de nombreuses tensions de référence sont exacerbées par le souci accru d'une part de ne pas stresser les cellules mémoire en opérationnel et donc de leur appliquer à tout moment les tensions optimums correspondant à chaque mode d'accès, et de disposer d'autre part de tous les moyens de test en interne.

Or il n'est pas envisageable de fournir toutes ces tensions de référence sur des bornes d'alimentation du circuit : la multiplicité des sources externes serait un inconvénient majeur pour l'utilisateur et la multiplicité des bornes d'alimentation spécifiques externes est un inconvénient majeur pour le fabricant, car elle grève le coût des circuits. Il faut donc trouver des solutions internes au circuit. Une solution interne connue pour des applications à faible courant est la pompe de charges : à partir d'une tension nominale, on obtient une tension plus élevée par effet multiplicatif. Outre que cette solution ne convient pas pour les applications à fort courant, il faut de plus autant de pompes de charges que de tensions de références internes.

Dans l'invention, on propose un dispositif capable de délivrer un niveau de tension déterminé, au choix parmi plusieurs possibles. Dans un perfectionnement, la tension de référence délivrée est stable, indépendante du courant de charge du circuit auquel elle est appliquée. Ce dispositif permet de fournir à un circuit l'ensemble des tensions de référence nécessaire, par sélection logique.

Dans l'invention on utilise des rapports résistifs dans une chaîne de résistances pour obtenir différents niveaux de tension et des transistors pour établir une tension de référence stable en sortie, fonction d'un rapport résistif sélectionné.

Telle qu'elle est revendiquée, l'invention concerne un dispositif de génération de tensions de référence avec un étage de génération qui comporte :
- un premier transistor placé entre une source de tension positive et une sortie de l'étage de génération ayant sa grille polarisée à un premier potentiel;
- au moins un deuxième et un troisième transistors en parallèle, identiques au premier, chacun ayant sa grille polarisée à un potentiel respectif et étant monté en série avec un transistor de commutation respectif entre la sortie de l'étage de génération et la masse;
- une chaîne de résistances en série entre la source de tension positive et la masse pour délivrer les différents potentiels de polarisation des grilles des transistors;
- des moyens logiques pour rendre conducteur un seul transistor de commutation déterminé à la fois, pour générer un niveau de tension déterminé sur la sortie de l'étage de génération.

L'invention concerne aussi une mémoire non-volatile munie de ce dispositif. Avantageusement, le dispositif sera commandé par le décodeur d'instruction de la mémoire pour sélectionner un niveau de tension de sortie déterminé correspondant à une instruction décodée.

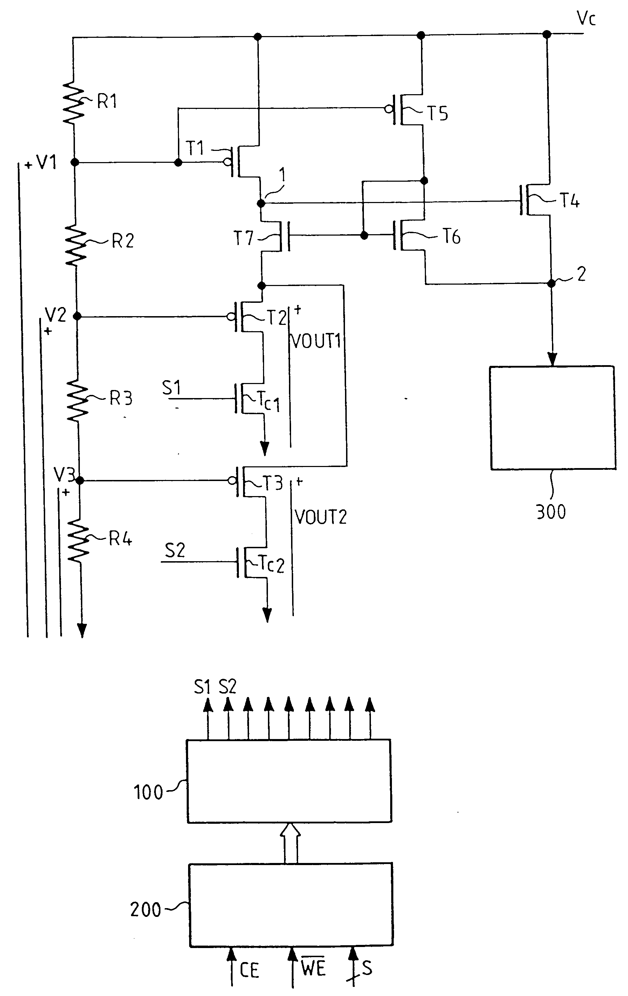

D'autres caractéristiques et avantages de l'invention sont donnés dans la description qui suit à titre indicatif et nullement limitatif, en référence à la figure unique annexée qui représente un dispositif de tensions de référence selon l'invention.

Le dispositif de tensions de référence selon l'invention comporte principalement un étage de génération d'une tension de référence sur une sortie 1.

Un transistor T1 est monté entre une source de tension positive Vc et la sortie 1 de l'étage de génération.

Un transistor T2 est monté en série avec un transistor de commutation Tc1 entre la sortie 1 et la masse.

Un transistor T3 est monté en série avec un transistor de commutation Tc2 entre la sortie 1 et la masse.

Les grilles des transistors T1, T2, et T3 sont respectivement polarisées par des potentiels issus d'une chaîne de résistances R1, R2, R3, R4 en série entre la source de tension positive Vc et la masse. Dans l'exemple de la figure, R1 est connectée à Vc et R4 à la masse. La grille du transistor T1 est reliée au point d'interconnexion entre R1 et R2. La grille du transistor T2 est reliée au point d'interconnexion entre R2 et R3. La grille du transistor T3 est reliée au point d'interconnexion entre R3 et R4.

Les grilles des transistors de commutation Tc1, Tc2 sont commandées par des signaux logiques S1, S2 issus d'un circuit logique de commutation 100. Un seul des transistors de commutation peut être conducteur à la fois. Dans l'exemple, soit Tc1 est conducteur, soit Tc2 est conducteur soit aucun n'est conducteur. Ces transistors de commutation ont une résistance équivalente très faible en conduction. On les assimile à un circuit ouvert (résistance ∞) ou fermé (résistance nulle).

Le fonctionnement de l'étage de génération est alors le suivant :

Supposons que les signaux logiques S1 et S2 sont respectivement dans un état logique 1 et 0. Le transistor Tc1 est conducteur et ramène le drain du transistor T2 à la masse. Le transistor Tc2 est bloqué et le transistor T3 est donc bloqué également.

La source du transistor T1 étant polarisée à la tension positive Vc, le potentiel V1 de polarisation de la grille du transistor T1 va imposer le régime saturé. Le courant de saturation I va alors faire passer le transistor T2 en régime saturé également, la grille du transistor T2 étant polarisée au potentiel V2. Les deux transistors T1 et T2 étant identiques, il s'ensuit qu'à l'équilibre le régime de saturation s'établit pour les deux transistors avec la même tension grille-source.

La tension de sortie de l'étage de génération s'en déduit aisément.

En effet, on a :

$$V1 = \frac{R2 + R3 + R4}{R1 + R2 + R3 + R4} Vc \text{ et } V2 = \frac{R3 + R4}{R1 + R2 + R3 + R4} Vc$$

L'équation d'équilibre s'écrit :

V1 - Vs1 = V2 - Vs2 où Vs1 et Vs2 sont les potentiels de source respectivement des transistors T1 et T2 et V1, V2 leurs potentiels de grille (tous ces potentiels sont référencés par rapport à la masse).

On a aussi Vs1 = Vc et Vs2 = VOUT1 = tension de sortie de l'étage de génération quand T2 est conducteur et T3 bloqué,

d'où

$$VOUT1 = V2 - V1 + Vc = \frac{R1 + R3 + R4}{R1 + R2 + R3 + R4} Vc$$

Supposons maintenant que les signaux logiques S1 et S2 sont respectivement dans un état logique 0 et 1. Le transistor Tc2 est conducteur et ramène le drain du transistor T3 à la masse. Le transistor Tc1 est bloqué, et le transistor T2 est donc bloqué également.

De la même manière que précédemment, le transistor T1 va imposer son courant de saturation, mais cette fois-ci au transistor T3 qui va passer en régime saturé. Les deux transistors T1 et T3 étant identiques, il s'ensuit qu'à l'équilibre le régime de saturation s'établit pour les deux transistors avec la même tension grille-source.

La tension de sortie de l'étage de génération s'en déduit aisément :

En effet on a :

$$V1 = \frac{R1 + R3 + R4}{R1 + R2 + R3 + R4} Vc \text{ et } V3 = \frac{R4}{R1 + R2 + R3 + R4} Vc$$

L'équation d'équilibre s'écrit :

V1 - Vs1 = V3 - Vs3 où Vs1 et Vs3 sont les potentiels de source respectivement des transistors T1 et T3 et V1, V3 leurs potentiels de grille (tous ces potentiels sont référencés par rapport à la masse).

On a aussi Vs1 = Vc et Vs3 = VOUT2 = tension de sortie de l'étage de génération quand T3 est conducteur et T2 bloqué, d'où :

$$VOUT2 = \frac{R1 + R4}{R1 + R2 + R3 + R4} Vc$$

Pour une tension Vc donnée, les tensions de sortie ne vont dépendre que du choix des valeurs de résistances, et des rapports résistifs.

Dans un exemple numérique, on a :

```
Vc = 12 volts

R1 = 3 KΩ

R2 = 5 KΩ          V1 = 9 volts

R3 = 1 KΩ          V2 = 4 volts          VOUT1 = 7 volts

R4 = 3 KΩ          V3 = 3 volts          VOUT2 = 6 volts
```

Dans une application à une mémoire flash EPROM, la tension de drain d'une cellule en programmation sera VOUT2 (6 volts) en programmation normale, tandis qu'en test, elle sera VOUT1 (7 volts).

Plus généralement, pour une mémoire non-volatile, on prévoit avantageusement dans l'invention de commander les transistors de commutation Tc1, Tc2 par un circuit de décodage des instructions 200 de manière à sélectionner le niveau de tension correspondant à l'instruction décodée : lecture, programmation, effacement, test ... etc. Ce circuit de décodage reçoit au moins le signal de sélection de la mémoire CE et le signal de lecture/écriture de la mémoire /WE. Il reçoit de manière générale tous les signaux S nécessaires à identifier une opération particulière sur la mémoire.

Dans un perfectionnement de l'invention, on place un étage de sortie (délimité en pointillé sur la figure unique) après l'étage de génération pour stabiliser la tension de sortie par compensation de ses variations par le courant de charge.

L'étage de sortie comporte de préférence un transistor T4 de géométrie large pour conduire un fort courant. Il est commandé sur sa grille par la sortie 1 de l'étage de génération et il est connecté entre la source de tension Vc et la sortie 2 de l'étage de sortie.

L'étage de sortie comporte en outre trois transistors T5, T6 et T7 qui forment avec le transistor T1 un miroir de courant.

Les transistors T5 et T6 sont placés en série entre la source de tension positive Vc et la sortie 2 du dispositif. Le transistor T7 est placé en série avec le transistor T1 entre la sortie 1 de l'étage de génération et les autres transistors T2, T3 de cet étage. Le transistor T5 est identique à T1. Les transistors T6 et T7 sont identiques, de type de conduction opposé à celui des transistors T1, T5. Dans l'exemple, les transistors T1 et T5 sont de type P et les transistors T6 et T7 de type N.

Les grilles des transistors T6 et T7 sont reliées ensemble et au drain du transistor T6. Les grilles du transistor T5 et T1 sont reliées ensemble.

La sortie de l'étage de sortie est donnée dans l'exemple de la figure par le noeud commun 2 aux sources des transistors T6 et T4.

Les transistors T1 et T5 étant identiques, et polarisés de la même manière, le transistor T5 est aussi en régime saturé et impose au transistor T6 son courant de saturation, égal au courant de saturation du transistor T1.

Comme les transistors T7 et T6 sont identiques, que les transistors T1, T5, T7, T6 forment un miroir de courant et que les transistors T1 et T7 imposent le même courant de saturation, on retrouve la tension de référence de la sortie 1 de l'étage de génération sur le drain du transistor T6. Comme le transistor T6 a sa grille et son drain reliés ensemble, il est en saturation et la chute de potentiel entre grille et source du transistor T6 est égale à la tension grille-source du transistor T7. On retrouve donc la tension de l'étage de génération sur la sortie 2 de l'étage de sortie.

Si la tension sur la sortie 2 du dispositif est appliquée à un circuit d'application 300, la tension sur la sortie 2 peut diminuer à cause d'un appel de courant trop fort du circuit 300. La tension au drain du transistor T6 va alors diminuer et donc la tension de la grille du transistor T7 aussi. Le transistor T7 va donc laisser passer moins de courant. Comme le transistor T1 est en régime saturé, le courant de saturation est fixé.

C'est donc la tension de sortie de l'étage de génération qui va augmenter pour compenser la baisse de courant dans le transistor T7. La tension de grille du transistor T4 augmente donc et ce dernier conduit plus de courant : la tension sur la sortie 2 de l'étage de sortie va remonter. Les transistors T4, T5, T6 et T7 forment donc avec le transistor T1 une boucle de contre-réaction qui permet de maintenir la tension en sortie par des compensations de courant de charge.

On peut aisément modifier le dispositif de génération décrit pour obtenir plus de deux niveaux de tension en sortie : il suffit d'augmenter en conséquence le nombre de transistors en série avec un transistor de commutation ( T2, Tc1; T3, Tc2; T4, Tc3; ...etc) et de choisir une chaîne de résistances appropriée pour obtenir les niveaux de tension désirés.

## Revendications

1. Dispositif de génération de tensions de référence comportant un étage de génération comprenant :
   - un premier transistor (T1) placé entre une source de tension positive (Vc) et une sortie (1) de l'étage de génération ayant sa grille polarisée à un premier potentiel (V1);
   - au moins un deuxième (T2) et un troisième (T3) transistors en parallèle, identiques au premier (T1), chacun ayant sa grille polarisée à un potentiel respectif (V2 et V3) et étant monté en série avec un transistor de commutation respectif entre la sortie (1) de l'étage de génération et la masse;
   - une chaîne de résistances en série (R1 à R4) entre la source de tension positive (Vc) et la masse pour délivrer les différents potentiels (V1, V2, V3) de polarisation des grilles des transistors;
   - des moyens logiques (100) pour rendre conducteur un seul transistor de commutation déterminé à la fois, pour générer un niveau de tension déterminé sur la sortie (1) de l'étage de génération.

**2.** Dispositif de génération de tensions de référence selon la revendication 1, caractérisé en ce qu'il comporte en outre un étage de sortie comprenant :

- un quatrième transistor (T4) apte à conduire un fort courant, commandé sur sa grille par la sortie (1) de l'étage de génération, et connecté entre la source de tension positive (Vc) et une sortie (2) du dispositif;
- un cinquième (T5) et un sixième (T6) transistors en série entre la source de tension positive (Vc) et la sortie (2) du dispositif, le sixième transistor(T6) ayant une électrode de conduction reliée à sa grille de commande et une autre à la sortie du dispositif;
- un septième transistor (T7) en série entre le premier transistor (T1) et les autres transistors (T2, T3) de l'étage de génération;

le premier transistor (T1) et le cinquième transistor (T5) étant identiques et ayant leurs grilles reliées ensemble, le sixième (T6) et le septième (T7) transistor étant identiques, ayant leurs grilles reliées ensemble, et de type de conduction opposée à celui des premier et cinquième transistors.

**3.** Mémoire électriquement programmable comportant un dispositif de génération de tensions de référence selon la revendication 1 ou 2.

**4.** Mémoire électriquement programmable selon la revendication 3, caractérisée en ce que les moyens logiques (100) pour rendre conducteur un transistor de commutation donné sont commandés par des moyens de décodage des instructions (200) afin de sélectionner un niveau de tension déterminé en fonction d'une instruction décodée.


**Patentansprüche**

**1.** Vorrichtung zur Erzeugung von Bezugsspannungen, aufweisend eine Erzeugungsstufe, umfassend:

- einen ersten Transistor (T1), angeordnet zwischen einer positiven Spannungsquelle (Vc) und einem Ausgang (1) der Erzeugungsstufe, dessen Steuerelektrode auf ein erstes Potential (V1) polarisiert ist;
- wenigstens einen zweiten (T2) und einen dritten (T3) zum ersten (T1) identischen, parallelen Transistor, deren Steuerelektrode jeweils auf ein entsprechendes Potential (V2 und V3) polarisiert ist und die in Reihe mit einem entsprechenden Schalttransistor zwischen dem Ausgang (1) der Erzeugungsstufe und der Masse geschaltet sind;
- eine Kette von Widerständen in Reihe (R1 bis R4) zwischen der positiven Spannungsquelle (Vc) und der Masse, um die verschiedenen Potentiale (V1, V2, V3) zur Polarisation der Steuerelektroden der Transistoren abzugeben;
- logische Mittel (100), um auf einmal einen bestimmten einzigen Schalttransistor leitend zu machen, um am Ausgang (1) der Erzeugungsstufe einen bestimmten Spannungspegel zu erzeugen.

**2.** Vorrichtung zur Erzeugung von Bezugsspannungen nach Anspruch 1, dadurch **gekennzeichnet**, daß sie außerdem eine Ausgangsstufe umfaßt, aufweisend:

- einen vierten Transistor (T4), geeignet zum Führen eines starken Stroms, der an seiner Steuerelektrode durch den Ausgang (1) der Erzeugungsstufe gesteuert ist und zwischen der positiven Spannungsquelle (Vc) und einem Ausgang (2) der Vorrichtung angeschlossen ist;
- einen fünften (T5) und einen sechsten (T6) Transistor in Reihe zwischen der positiven Spannungsquelle (Vc) und dem Ausgang (2) der Vorrichtung, wobei eine Leitungselektrode des sechsten Transistors (T6) mit seiner Steuerelektrode und eine andere mit dem Ausgang der Vorrichtung verbunden ist;
- einen siebten Transistor (T7) in Reihe zwischen dem ersten Transistor (T1) und den weiteren Transistoren (T2, T3) der Erzeugungsstufe;

wobei der erste Transistor (T1) und der fünfte Transistor (T5) identisch sind und ihre Steuerelektroden miteinander verbunden sind, wobei der sechste (T6) und der siebte (T7) Transistor identisch sind, wobei ihre Steuerelektroden miteinander verbunden sind, und sie vom Leitfähigkeitstyp entgegengesetzt zu demjenigen des ersten und fünften Transistors sind.

**3.** Elektrisch programmierbarer Speicher, umfassend eine Vorrichtung zur Erzeugung von Bezugsspannungen nach Anspruch 1 oder 2.

4.  Elektrisch programmierbarer Speicher nach Anspruch 3, dadurch **gekennzeichnet,** daß die logischen Mittel (100) zum Leitendmachen eines gegebenen Schalttransistors durch Mittel zur Dekodierung der Instruktionen (200) gesteuert sind, um einen bestimmten Spannungspegel abhängig von einem dekodierten Befehl auszuwählen.

## Claims

1.  Device for generating reference voltages including a generation stage comprising:
    -   a first transistor (T1) placed between a positive voltage source (Vc) and an output (1) of the generation stage, having its gate biased at a first potential (V1);
    -   at least a second (T2) and a third (T3) transistor in parallel, identical to the first (T1), each having its gate biased at a respective potential (V2 and V3) and being mounted in series with a respective switching transistor between the output (1) of the generation stage and earth;
    -   a chain of resistors in series (R1 to R4) between the positive voltage source (Vc) and earth in order to deliver the different potentials (V1, V2, V3) for biasing the gates of the transistors;
    -   logic means (100) for making conductive a single switching transistor determined at any one time, in order to generate a given voltage level at the output (1) of the generation stage.

2.  Device for generating reference voltages according to Claim 1, characterised in that it also includes an output stage comprising:
    -   a fourth transistor (T4) suitable for conducting a high current, controlled at its gate by the output (1) of the generation stage and connected between the positive voltage source (Vc) and an output (2) of the device;
    -   a fifth (T5) and a sixth (T6) transistor in series between the positive voltage source (Vc) and the output (2) of the device, the sixth transistor (T6) having one conduction electrode connected to its control gate and another to the output of the device;
    -   a seventh transistor (T7) in series between the first transistor (T1) and the other transistors (T2, T3) of the generation stage;

    the first transistor (T1) and the fifth transistor (T5) being identical and having their gates connected together, the sixth (T6) and seventh (T7) transistors being identical, having their gates connected together, and being of the conduction type opposite to that of the first and fifth transistors.

3.  Electrically programmable memory including a device for generating reference voltages according to Claim 1 or 2.

4.  Electrically programmable memory according to Claim 3, characterised in that the logic means (100) for making a given switching transistor conductive are controlled by means for decoding instructions (200) in order to select a given voltage level in accordance with a decoded instruction.